(19) Europäisches Patentamt
European Patent Office
Office européen des brevets

(11) EP 2 662 983 A1

(12) EUROPEAN PATENT APPLICATION

(43) Date of publication:
13.11.2013 Bulletin 2013/46

(51) Int Cl.:
H03M 1/10 (2006.01)  H03M 1/06 (2006.01)

(21) Application number: 12167372.7

(22) Date of filing: 09.05.2012

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicant: NXP B.V.
5656 AG Eindhoven (NL)

(72) Inventors:
• Janssen, Erwin
Redhill, Surrey RH1 1NY (GB)

• Doris, Konstantinos
Redhill, Surrey RH1 1NY (GB)
• Zanikopoulos, Athon
Redhill, Surrey RH1 1NY (GB)
• Murroni, Alessandro
Redhill, Surrey RH1 1NY (GB)

(74) Representative: Miles, John Richard
NXP Semiconductors
Intellectual Property and Licensing
Red Central
60 High Street
Redhill, Surrey RH1 1SH (GB)

(54) **Analogue-to-digital converter**

(57) An analogue-to-digital converter, ADC, for converting an analogue input signal (Vin) into a digital signal (output) is disclosed. The ADC comprises a correction unit (15) adapted to generate a correction signal, which offsets the output signal from a feedback DAC configured to produce an analogue representation of the digital signal (output) so that the offset output signal (Vdac) has the same common-mode or bias point as the input signal (Vin).

Figure 3

**Description**

This invention relates to an analogue-to-digital converter (ADC).

WO2010/044000 describes a method that enables the use of a non-linear amplifier in a time-interleaved ADC that is built up from several successive approximation sub-ADCs. This technique has proven to be very powerful. The technique described enables the non-linearity of a buffer or amplifier to be cancelled. This allows a faster, lower-power amplifier to be used, which is easier and cheaper to realise. Even with the traditional approach of using a higher-power buffer amplifier some non-linearity will be present. This technique enables an inherently non-linear amplifier to be linearised.

However, there is a problem with this technique that is likely to limit its performance when used with future generation products. Specifically, the approach is only able to compensate for the non-linearity of the amplifier fully if the common-mode point (for differential signals) or bias point (for single-ended signals) of the input signal and the feedback signal from the digital-to-analogue converter (DAC) in the successive approximation unit are identical.

In practical realizations, especially in time-interleaved ADCs where there are many such feedback DACs, this cannot be realized by design, and as a result distortion will be introduced during the analog-to-digital conversion process.

Indeed, this problem is generally relevant to the majority of different types of ADCs (i.e. not just to successive approximation ADCs) because the use of feedback DACs to generate an analogue representation of the current digital approximation of an analogue input signal is almost ubiquitous in ADCs. Thus, a mismatch between the common-mode point or bias point of the input signal and the feedback signal from the DAC will be found in most types of ADC.

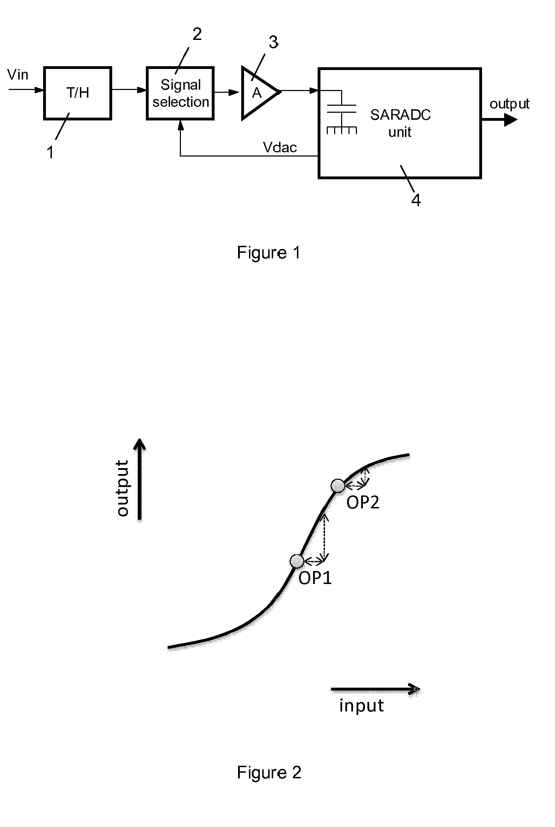

The result of this problem is explained in more detail with reference to Figure 1, which shows a block diagram of an ADC utilising the scheme. An input signal to be converted is received by a track-and-hold circuit 1. A signal selector 2 then selects either the signal from the track-and-hold circuit 1 or a feedback signal from a DAC in a successive approximation register 4 and couples it to the input of amplifier 3. Amplifier 3 is non-linear, but since both the sampled input signal and the DAC feedback signal are passed through the same amplifier 3, the non-linearity should be compensated. However, the operating point of the non-linear amplifier 3 is different for the input signal and the feedback signal from the DAC in the successive approximation register, and therefore the non-linearity will only be compensated partially.

The reason for this can be seen from Figure 2, which shows an example of a transfer curve for a typical non-linear amplifier. It can be easily seen that an equal change of the amplifier input signal will result in a different change of the output signal at each of the operating points OP1 and OP2. Thus, if the input signal to be converted causes the amplifier 3 to operate around operating point OP1, and the DAC feedback signal around point OP2, the change in output signal for the same change in input signal will not correspond between the input signal to be converted and the DAC feedback signal. The ADC will therefore introduce distortion when it matches the DAC feedback signal to the input signal to be converted.

According to a first aspect of the invention, there is provided an analogue-to-digital converter (ADC) for converting an analogue input signal into a digital signal, the ADC comprising a correction unit adapted to generate a correction signal, which offsets the output signal from a feedback DAC configured to produce an analogue representation of the digital signal so that the offset output signal has the same common-mode or bias point as the input signal.

Hence, by generating a correction signal that offsets the output signal from the feedback DAC, it is possible to adjust the output signal from the feedback DAC so that it has the same common-mode or bias point as the input signal, thereby overcoming the problem mentioned above. This in turn enables the non-linearity in a buffer amplifier forming part of an ADC to be compensated in a variety of ways, as detailed below.

As will be appreciated by those skilled in the art, the DAC serves the purpose of generating an analogue representation of a current approximation of the input signal to be converted. In order to make the conversion of the input signal to be converted, the output from the DAC is compared with the input signal to achieve the best approximation. Often this is done by successive approximations.

In a first embodiment, the correction unit is adapted to generate the correction signal to be equal to half the difference between the number of binary codes the DAC is responsive to and the maximum number of binary codes that each of a plurality of further DACs associated with the ADC is responsive to.

The plurality of further DACs associated with the DAC are normally integrated on the same device.

In a second embodiment, the correction unit is adapted to generate the correction signal to be equal to half the difference between the number of binary codes the DAC is responsive to and the theoretical maximum possible number of binary codes that each of a plurality of further DACs associated with the ADC is responsive to.

Again, the plurality of further DACs associated with the DAC are normally integrated on the same device.

The theoretical maximum possible number of binary codes is typically based on an assumption as to the maximum possible number of binary codes to which any of the further DACs may be responsive. For example, it may be based on an assumption that the maximum possible number of binary codes to which any of the further DACs may be responsive is at four times the standard deviation from the mean of the maximum number of binary codes to which all of the plurality of further DACs is responsive.

The ADC may further comprise a buffer amplifier and an input selector adapted to couple an input of the buffer amplifier to either an input signal for conversion or the output signal from the DAC, the DAC forming part of a successive approximation unit to which an output of the buffer amplifier is coupled, wherein the correction signal generated by the correction unit offsets the output signal from the DAC so as to cause the buffer amplifier to operate at a desired operating point.

The desired operating point is typically chosen to be the DC bias point or the common-mode point of the input signal for conversion.

With this arrangement, it is possible to influence the operating point of the buffer amplifier such that, when the input selector couples the output signal from the DAC to the buffer amplifier, it is the same as that when the input selector couples the input signal for conversion to the buffer amplifier. The non-linearity in the buffer amplifier is therefore perfectly compensated, and the above-mentioned problem is overcome.

In the terms of Figure 2, the operating point OP2 can be made equal to operating point OP1, and the (non-linear) change in the output signal is then the same for both signals and the non-linearity is perfectly compensated, resulting in a linear conversion.

The correction unit typically comprises a correction DAC, which converts a binary code representing the correction signal into the correction signal.

The ADC may further comprise an adder for offsetting the output signal from the DAC.

The ADC may additionally further comprise an input correction unit adapted to generate an input correction signal, which offsets the input signal for conversion to have a desired common-mode or DC bias point. Thus, the input correction unit may cause a buffer amplifier to operate at the desired operating point. This is only required if the input signal for conversion is not already at the DC bias point or common-mode point required to cause the buffer amplifier to operate at the desired operating point. The input correction unit may comprise a DC restorer or other bias circuitry.

In a second aspect of the invention, a time-interleaved ADC comprises a plurality of ADCs according to the first aspect of the invention.

In a third aspect of the invention, a time-interleaved ADC comprises a plurality of ADCs according to the first aspect of the invention, wherein the time-interleaved ADC further comprises a common input correction unit adapted to offset a common input signal to have a desired common-mode or DC bias point.

Examples of the invention will now be described in detail with reference to the accompanying drawings, in which:

Figure 1 shows a prior art ADC comprising a non-linear buffer amplifier;
Figure 2 shows a typical non-linear transfer characteristic for such a buffer amplifier;
Figure 3 shows an ADC according to the invention; and
Figure 4 shows a time-interleaved ADC according to the invention.

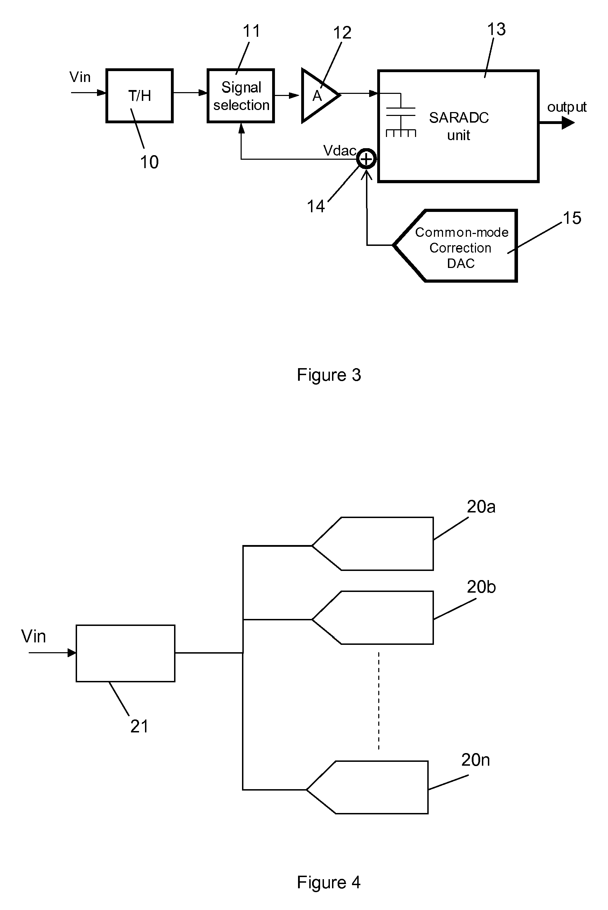

The invention works by adjusting the DC bias point or common-mode point of an input buffer amplifier when it is coupled to a feedback DAC in a successive approximation unit so that it is the same as when the buffer amplifier is coupled to an input signal for conversion. A block diagram of an ADC according to the invention is shown in Figure 3, in which a track-and-hold circuit 10 receives an input signal to be converted ($V_{in}$). The track-and-hold circuit 10 follows fluctuations in the input signal to be converted and holds the value of the signal when a hold input (not shown) is asserted.

The output from the track-and-hold circuit 10 is coupled to a first input of a signal selector 11. The output from the signal selector is coupled to a buffer amplifier 12, the output of which is in turn coupled to a successive approximation unit 13. The successive approximation unit 13 works in the conventional way by making a series of successive digital approximations to the analogue value of the signal to be converted (i.e. at the output of buffer amplifier 12 when the input selector is coupling the track-and-hold circuit 10 to the buffer amplifier 12). Each of the successive digital approximations is converted to an analogue representation by a feedback DAC within the successive approximation unit 13 and compared to the analogue value of the signal to be converted. During this comparison process, the signal selector 11 couples the output from the feedback DAC, which is coupled to the second input of the signal selector 11, to the buffer amplifier 12 input.

The output from the feedback DAC is coupled to the input selector 11 via an adder 14 which is used to offset the signal from the feedback DAC by an amount equal to the output signal generated by a correction DAC 15. The correction DAC 15 converts a value stored in a non-volatile register into analogue. The value stored in the non-volatile register is selected during manufacture of the ADC to offset the output signal generated by a correction DAC 15 by a suitable amount such that it causes the DC bias point or common-mode point of buffer amplifier 12 to be the same when the input selector 11 couples the output from the feedback DAC to buffer amplifier 12 as when the input selector 11 couples the signal to be converted to the buffer amplifier 12. In alternative embodiments, a volatile memory is used in place of the non-volatile register, and the value stored in the memory is one that results from a calibration performed at power-on to find the optimal code or from a background calibration process that operates whilst the ADC is active.

As explained above the operating point of an amplifier is the DC bias point or common-mode point about which the input signal fluctuates. In the case of a single-ended signal, where the signal varies between $V_1$ and $V_2$, the operating point or DC bias point is $(V_1+V_2)/2$. In the case of a differential signal the operating point is equal to the common-mode point.

In CMOS IC processes where the minimum supply level is 0V (because there is no negative supply), the operating point is typically selected such that the minimum voltage that is required to represent a signal is at least 0V. This means that in the single-ended case V1 is selected to be at least 0V. In the differential case the minimum signal voltage will be present on one of the input pins of the amplifier at both minimum and maximum signal levels. For a maximum signal level, the voltages on the input pins will be $V_{common} \pm V_{max}$, where $V_{common}$ represents the common-mode point of the amplifier and $V_{max}$ the maximum signal amplitude in volts. Thus, in order to stay above 0V it is required that $V_{common}$ is at least $V_{max}$.

In a practical ADC, there will be many (for example, 64) ADCs all fed from the same input signal. Each will have its own feedback DAC. The point around which the output of each feedback DAC varies (and thus, which sets the common-mode point of the buffer amplifier 11) is not actively controlled or set, but is an inherent property of the feedback DAC and varies with process variations and process mismatch. As a result, the common-mode point of the input amplifiers of every DAC feedback signal in the integrated circuit will be slightly different, which causes distortion.

In the ADC, the feedback DACs are typically differential current-steering DACs with a resistor load. They have a minimum output voltage of 0V, and a maximum output voltage of $V_{fullscale(DAC)}$. The common-mode voltage of the DAC is equal to half the maximum output voltage it can produce, and is equal to:

$$V_{common-mode(DAC)} = V_{fullscale(DAC)}/2.$$

Because there are many ADC units in the ADC, each unit is required to occupy a very small area. As a result, there is often a large mismatch and the inherent quality of each ADC unit is very low. By means of calibration the ADC units are corrected for offset, gain, and linearity errors of the feedback DACs. After calibration, each feedback DAC is characterized and is guaranteed to be responsive to at least 1024 output codes (10-bit level), but it is also possible that a feedback DAC could be responsive to 1100 output codes. Each feedback DAC is calibrated such that the input signal to the feedback DAC at full scale can be represented using no more than 1024 codes. Thus, after calibration the output swing of each feedback DAC is such that with 1024 codes the swing of the ADC input signal can be matched. Other converters with more or fewer bits than 10 will require different numbers of codes.

The maximum swing each feedback DAC can generate is:

$$V_{fullscale(DAC)} = (\text{\#DACcodes} / 1024) * V_{fullscale(input)}$$

where:

$V_{fullscale(DAC)}$ is the output of the feedback DAC at full scale;
#DACcodes is the number of codes the feedback DAC is responsive to; and
$V_{fullscale(input)}$ is the full scale value of the ADC input signal.

Thus, if the DAC is, for example, able to generate 1100 codes and $V_{fullscale(input)}$ = 0.5V, the maximum output of the DAC will be:

$$V_{fullscale(DAC)} = (1100/1024) * 0.5V = 0.5371V.$$

From the maximum DAC output voltage, it is possible to derive the common-mode voltage of the DAC as:

$$V_{common-mode(DAC)} = V_{fullscale(DAC)}/2 = 268.6mV.$$

If the DAC is able to generate 1024 codes, the common-mode voltage will be 250mV (i.e. half the full-scale input voltage). Thus, it can be seen that the common-mode voltage can vary by up to 18.6mV. If the buffer amplifier 12 is minimally non-linear this does not cause a strong degradation in conversion linearity. However, in some circumstances the buffer amplifier 12 is required to provide a high gain and has a structure that is also highly non-linear. This causes an increase of the SNR, but if the common-mode variation is not reduced will also cause a strongly non-linear conversion, which degrades signal conversion performance.

From the description above it can be understood that a feedback DAC that is responsive to the minimum number of codes has the lowest common-mode voltage, and a feedback DAC responsive to the maximum number of codes has the highest common-mode voltage. In order to be able to match the common-mode voltage of all the different feedback DACs in an ADC integrated circuit to the common-mode voltage of the input, it is required to match the common-mode of all the DACs. This is achieved by the correction DAC 15 and adder 14 in Figure 3 that compensate the common-mode voltage of the DAC.

Since the signal voltages can only be positive in CMOS, the correction DAC 15 is required to provide a positive offset to the feedback DAC output signal to increase the common-mode voltage such that for every feedback DAC output the compensated voltage always stays positive. As a result of this, in the case of multiple ADC units that require the same common-mode voltage, it is necessary to increase the common-mode voltage of each feedback DAC to the maximum common-mode voltage that is present amongst all the feedback DACs in the ADC before correction (i.e. to the common-mode voltage of the DAC that is responsive to the maximum number of codes). The required amount of common-mode compensation, expressed in single-ended least significant bits, can be directly calculated by subtracting the number of codes the feedback DAC that is being corrected is responsive to from the maximum number of codes that any feedback DAC is responsive to, and dividing this value by two:

$$correction\_amount = (max\_\#codes\_present - \#codes) / 2$$

The value of the correction amount is stored in the non-volatile register for conversion into an analogue signal by correction DAC 15, which offsets the output of the feedback DAC using adder 14.

By correcting all the feedback DACs with this procedure the common-mode voltage of every feedback DAC will be equal. However, the common-mode voltage of each feedback DAC will not be equal to the input signal's common-mode voltage. In addition to this, the common-mode voltage of the feedback DACs will differ from integrated circuit to integrated circuit, because it depends on the actual mismatch of the integrated circuit.

In order to solve these problems the common-mode voltage of the input signal has to be adjusted. This can be done using a DC restorer or other bias circuitry to offset the input signal to be converted to the desired common-mode point. Then, the buffer amplifier 12 will be caused to work at the same operating point irrespective of whether the signal selector 11 couples the input signal to be converted or the output of the feedback DAC to it, and the non-linearity of the buffer amplifier 12 is compensated.

Figure 4 illustrates such an approach applied to a time-interleaved ADC, in which a plurality of ADCs 20a, 20b to 20n (n being an arbitrary number) according to the embodiment in Figure 3 are configured together to convert an analogue input signal into a digital representation (i.e. each ADC being clocked to perform a conversion in its own respective distinct phase). A DC restorer (or other bias circuitry) 21 is provided to offset the input signal by an appropriate amount so that it lies on the desired common-mode point. The output from DC restorer 21 is provided in parallel to the inputs of each of the ADCs 20a, 20b to 20n.

In Figure 4, each ADC 20a - 20n can comprise all of the components of Figure 3. However, the track and hold unit 10 is not necessarily present in each ADC, so that a shared track and hold unit can drive a set of the ADCs, and there can be only one such set (i.e. only one track and hold unit) or multiple sets (i.e. multiple track and hold units each driving respective set of ADCs).

As an alternative to adjusting the common-mode voltage of the input signal, it is possible to calibrate the common-mode voltage of each feedback DAC to a fixed level that does not depend on the actual mismatch. This is possible because the output swing of each feedback DAC is known after calibration. This is done by calibrating the common-mode voltage to the maximum common-mode voltage that would be present if the feedback DAC being calibrated could respond to a theoretical maximum number of codes. The theoretical maximum number of codes is determined using an assumption that the spread in values could never exceed a range of, for example, four standard deviations from the mean of the number of codes that all the feedback DACs could respond to on a particular integrated circuit. The common-mode correction amount is in this case equal to the difference between the theoretical maximum number of codes possible and the actual number of codes of the feedback DAC being calibrated divided by two:

$$correction\_amount = (theoretical\_max\_\#codes\_possible - \#codes) / 2.$$

This approach makes it possible to design a structure that adjust the common-mode voltage of each feedback DAC to match that of the input common-mode voltage, and to have an accurate match between the input common-mode voltage and the feedback DAC common-mode voltage. The techniques described above allow a high signal conversion quality to be achieved at a high sampling rate.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

**Claims**

1. An analogue-to-digital converter (ADC) for converting an analogue input signal into a digital signal, the ADC comprising a correction unit (15) adapted to generate a correction signal, which offsets the output signal from a feedback DAC configured to produce an analogue representation of the digital signal so that the offset output signal has the same common-mode or DC bias point as the input signal.

2. An ADC according to claim 1, wherein the correction unit (15) is adapted to generate the correction signal to be equal to half the difference between the number of binary codes the DAC is responsive to and the maximum number of binary codes that each of a plurality of further DACs associated with the ADC is responsive to.

3. An ADC according to claim 1, wherein the correction unit (15) is adapted to generate the correction signal to be equal to half the difference between the number of binary codes the DAC is responsive to and the theoretical maximum possible number of binary codes that each of a plurality of further DACs associated with the ADC is responsive to.

4. An ADC according to any of the preceding claims, further comprising a buffer amplifier (12) and an input selector (11) adapted to couple an input of the buffer amplifier (12) to either an input signal for conversion or the output signal from the DAC, the DAC forming part of a successive approximation unit (13) to which an output of the buffer amplifier (12) is coupled, wherein the correction signal generated by the correction unit (15) offsets the output signal from the DAC so as to cause the buffer amplifier (12) to operate at a desired operating point.

5. An ADC according to any of the preceding claims, wherein the correction unit comprises a correction DAC (15), which converts a binary code representing the correction signal into the correction signal.

6. An ADC according to claim 5, further comprising a non-volatile register for storing the binary code representing the correction signal.

7. An ADC according to any of the preceding claims, further comprising an adder (14) for offsetting the output signal from the DAC.

8. An ADC according to any of the preceding claims, further comprising an input correction unit adapted to generate an input correction signal, which offsets the input signal for conversion to have a desired common-mode or DC bias point.

9. A time-interleaved ADC comprising a plurality of ADCs (20a, 20b - 20n) according to any of the preceding claims.

10. A time-interleaved ADC comprising a plurality of ADCs (20a, 20b - 20n) according to any of claims 1 to 7, wherein the time-interleaved ADC further comprises a common input correction unit (21) adapted to offset a common input signal to have a desired common-mode or DC bias point.

Figure 1

Figure 2

Figure 3

Figure 4

EP 2 662 983 A1

Europäisches
Patentamt
European
Patent Office
Office européen
des brevets

# EUROPEAN SEARCH REPORT

Application Number

EP 12 16 7372

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAI ZHANG ET AL: "A 53-nW 9.1-ENOB 1-kS/s SAR ADC in 0.13- $\mu$ m CMOS for Medical Implant Devices", IEEE JOURNAL OF SOLID-STATE CIRCUITS, IEEE SERVICE CENTER, PISCATAWAY, NJ, USA, vol. 47, no. 7, 26 April 2012 (2012-04-26), - 1 July 2012 (2012-07-01), pages 1585-1593, XP011448449, ISSN: 0018-9200, DOI: 10.1109/JSSC.2012.2191209 | 1,4 | INV. H03M1/10 H03M1/06 |
| Y | * page 1586, right-hand column * <br> * page 1586, left-hand column * <br> * page 1589, left-hand column * <br> * figures 2,3,4,8 * | 1-3,5,6, 8-10 | |
| X | MOGNON V R ET AL: "Capacitive-SAR ADC input offset reduction by stray capacitance compensation", DEVICES, CIRCUITS AND SYSTEMS, 2008. ICCDCS 2008. 7TH INTERNATIONAL CARIBBEAN CONFERENCE ON, IEEE, PISCATAWAY, NJ, USA, 28 April 2008 (2008-04-28), pages 1-6, XP031272631, ISBN: 978-1-4244-1956-2 | 1,4,7 | TECHNICAL FIELDS SEARCHED (IPC) <br> H03M |
| Y | * page 1, right-hand column * <br> * page 4, left-hand column * <br> * page 3, right-hand column * <br> * Equation 4 * <br> * figures 1,2,3,6 * | 1-3,5,6, 8-10 | |

-/--

The present search report has been drawn up for all claims

| Place of search | Date of completion of the search | Examiner |
|---|---|---|
| The Hague | 7 November 2012 | Rocha, Daniel |

Europäisches
Patentamt

European
Patent Office

Office européen
des brevets

## EUROPEAN SEARCH REPORT

Application Number

EP 12 16 7372

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KOSTAS DORIS ET AL: "A 480 mW 2.6 GS/s 10b Time-Interleaved ADC With 48.5 dB SNDR up to Nyquist in 65 nm CMOS", IEEE JOURNAL OF SOLID-STATE CIRCUITS, IEEE SERVICE CENTER, PISCATAWAY, NJ, USA, vol. 46, no. 12, 1 December 2011 (2011-12-01), pages 2821-2833, XP011379207, ISSN: 0018-9200, DOI: 10.1109/JSSC.2011.2164961 <br> * page 2823, left-hand column * <br> * page 2828, right-hand column - page 2829, left-hand column * <br> * figures 3,11,12,13,14,17 * <br> ----- | 1-3,5,6, 8-10 | |
| | | | TECHNICAL FIELDS SEARCHED (IPC) |

The present search report has been drawn up for all claims

| Place of search | Date of completion of the search | Examiner |
|---|---|---|
| The Hague | 7 November 2012 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2010044000 A